(19) Europäisches Patentamt

European Patent Office

Office européen des brevets

(11) **EP 1 717 775 A1**

(12) **EUROPÄISCHE PATENTANMELDUNG**

(43) Veröffentlichungstag:
   **02.11.2006   Patentblatt 2006/44**

(51) Int Cl.:
   **G08C 19/02** (2006.01)      **G01D 18/00** (2006.01)
   **G01R 35/00** (2006.01)

(21) Anmeldenummer: **06007472.1**

(22) Anmeldetag: **08.04.2006**

(84) Benannte Vertragsstaaten:
   **AT BE BG CH CY CZ DE DK EE ES FI FR GB GR HU IE IS IT LI LT LU LV MC NL PL PT RO SE SI SK TR**
   Benannte Erstreckungsstaaten:
   **AL BA HR MK YU**

(30) Priorität: **28.04.2005   DE 102005020199**

(71) Anmelder: **Wieninger, Peter**
   **52072 Aachen (DE)**

(72) Erfinder: **Wieninger, Peter**
   **52072 Aachen (DE)**

(74) Vertreter: **Kohlmann, Kai**
   **Donatusstrasse 1**
   **52078 Aachen (DE)**

(54)   **Verfahren zur Eichung eines Schaltkreises mit einem Sensorsystem mit aktiver Halbleiterschaltung**

(57)   Die Erfindung betrifft ein Verfahren zur Eichung eines Schaltkreises mit einem Sensorsystem mit aktiver Halbleiterschaltung, das über eine Signalleitung mit einer Anzeigevorrichtung verbunden ist, die zugleich die Halbleiterschaltung mit Strom versorgt, wobei der minimale Anzeigewert der Anzeigevorrichtung bei einem ersten und der maximale Anzeigewert der Anzeigevorrichtung bei einem zweiten Stromwert erreicht wird, und das Sensorsystem eine steuerbare Stromsenke aufweist, die eine Einstellung des in der Signalleitung fließenden Stroms zwischen dem ersten und dem zweiten Stromwert erlaubt.

Um eine Eichung ohne ein Einstellelement an den Sensorsystem durchzuführen, wird erfindungsgemäß vorgeschlagen dass

- zur Durchführung der Eichung der Innenwiderstand des Schaltkreises zeitweilig geändert wird

- das Sensorsystem den Innenwiderstand erfasst und abhängig von dem erfassten Innenwiderstand zwischen dem Eichbetrieb und Normalbetrieb der Anzeigevorrichtung wechselt

- das Sensorsystem während der Eichung mindestens einen Messwert des Sensorssystems als Eichpunkt in einem Speicher ablegt und

- das Sensorsystem in Normalbetrieb der Anzeigevorrichtung den oder die im Speicher abgelegten Eichpunkte zur Berechnung von Korrekturwerten für die steuerbare Stromsenke verwendet, um auf der Anzeigevorrichtung den korrekten Wert anzuzeigen.

**Bild 3**

**Beschreibung**

**1. Gegenstand**

Die Erfindung betrifft ein Verfahren zur Eichung eines Schaltkreises mit einem Sensorsystem mit aktiver Halbleiterschaltung, das über eine Signalleitung mit einer Anzeigevorrichtung verbunden ist, die insbesondere zugleich die Halbleiterschaltung mit Strom versorgt, wobei der minimale Anzeigewert der Anzeigevorrichtung bei einem ersten und der maximale Anzeigewert der Anzeigevorrichtung bei einem zweiten Stromwert erreicht wird, und das Sensorsystem eine steuerbare Stromsenke aufweist, die eine Einstellung des in der Signalleitung fließenden Stroms zwischen dem ersten und dem zweiten Stromwert erlaubt.

Gegenstand dieser Erfindung ist ein Verfahren zur Festlegung von Eichpunkten bei modernen Sensorsystemen, ohne dass hierbei besondere technische Vorrichtungen erforderlich sind, um den Sensorsystemen Eichereignisse zu signalisieren.

**2. Stand der Technik**

Zur Darstellung von Betriebszuständen von Maschinen oder Installationen werden üblicherweise die Anzeigevorrichtungen an einem Ort konzentriert und Sensorsysteme werden über Leitungsverbindungen mit den Anzeigevorrichtungen verbunden. Um den Verbindungsaufwand gering zu halten und um die Sicherheit zu erhöhen wird hierbei angestrebt, die Anzahl der Signalisierungsleitungen gering zu halten.

In vielen Fällen kann der erforderliche Verdrahtungsaufwand auf eine Leitung reduziert werden. Hierbei wird das Anzeigegerät mit einem Anschluss auf die Hauptstromversorgung gelegt (üblicherweise der Pluspol). Der zweite Anschluss des Anzeigegerätes führt zum Sensorsystem.

Der geschlossene Stromkreis entsteht dadurch, dass direkt am Sensorsystem eine Verbindung zum Chassis (d.h. zur Stromversorgungs-Masse, üblicherweise Minuspol) des Gesamtgerätes hergestellt wird.

In herkömmlichen Realisationen ist der Sensor oft ein variabler Widerstand (z.B. NTC, PTC). Das Sensorsystem besteht also aus dem Sensor und einem Gehäuse mit geeigneten Anschlüssen.

Die Anzeigevorrichtung ist häufig ein Dreheiseninstrument zur Strommessung, wobei sich besonders der wertebereich 4..20mA durchgesetzt hat.

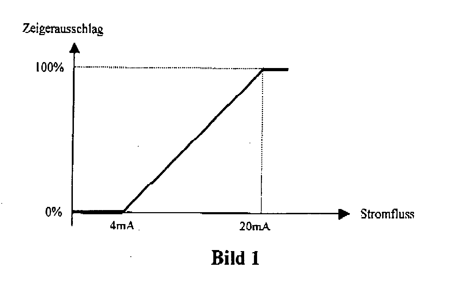

Bei solchen Instrumenten ergibt sich ein Anzeigewert von 0% bei einem Stromfluss zwischen 0mA und 4mA. Der Vollausschlag ergibt sich bei 20mA wie die durch Bild 1 verdeutlicht wird.

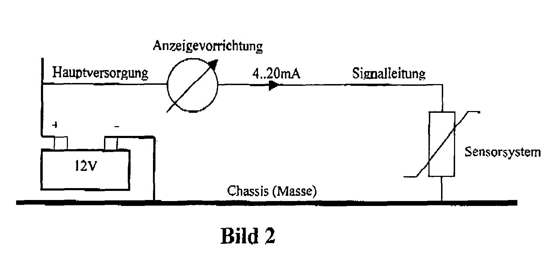

Diese herkömmlichen Sensorsysteme sind üblicherweise nicht eichtähig. Anzeigevorrichtung und Sensorsystem bilden eine technische Einheit, die werkseitig justiert wurde. Bild 2 zeigt eine typische Verschaltung eines herkömmlichen Sensorsystems mit der Anzeigevorrichtung

Neuere Sensorsysteme beinhalten häufig aktive Schaltungen (Halbleiterschaltungen).

Die Versorgung der aktiven Schaltung im Sensorsystem erfolgt häufig direkt aus der Signalleitung und das grundsätzliche Verhalten Sensorsystems ist damit ähnlich zu den herkömmlichen passiven Systemen.

Als exemplarische Realisation sei hier ein marktüblicher Füllstandssensor für Wassertanks vorgestellt. Solche Sensorsysteme werden durch Zulieferer der Automobilindustrie sowie der Freizeitindustrie (Caravan / Boot) zur Ermittlung des Füllstandes von Frischwasser- oder Brauchwassertanks vertrieben.

Die grundsätzliche Technik ist hier ähnlich wie in DE 102 58 417 B3 2004.08.12 realisiert.

Hierbei handelt es sich um einen kapazitiven Sensor, der den Flüssigkeitsstand zwischen zwei Stäben bestimmt. Die Kapazität C zwischen den Stäben ist in Gegenwart einer Flüssigkeit deutlich höher als die Freiluftkapazität.

Die Kapazitätsänderung wird durch aktive Halbleiterschaltungen bestimmt und mit einer steuerbaren Stromsenke wird ein variabler Stromfluss zwischen den Sensoranschlüssen eingeprägt.

Bei einem hohen Flüssigkeitsstand wird ein hoher Kapazitätswert ermittelt und es wird in Folge ein hoher Stromfluss (z.B. 20mA) erwirkt.

Bei niedrigem Flüssigkeitsstand wird ein niedriger Stromfluss (z.B. 4mA) erwirkt.

Dieser Stromfluss ist dann am Anzeigegerät sichtbar und gibt dem Benutzer Information über den Füllstand.

Solche Sensorsysteme sind häufig an bauliche Gegebenheiten anpassbar (z.B. durch Kürzen der Kapazitätsmessstäbe), wobei dann die werkseitige Eichung des Gesamtsystems nicht mehr gegeben ist.

Aus diesem Grund haben anpassbare Sensorsysteme oft ein oder mehrere Einstellelemente, um nach der Montage eine Eichung durchzuführen.

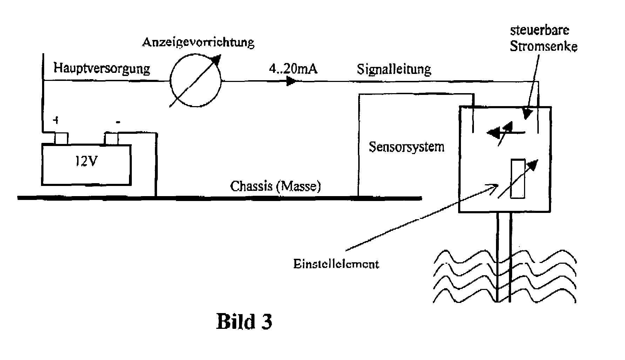

Bei dem hier vorgestellten beispielhaften handelsüblichen Sensorsystem wird ein Eichpunkt mit dem Einstellelement festgelegt, wie dies aus Bild 3 erkennbar ist.

Nach Auffüllen des Flüssigkeitstanks wird mit dem Einstellelement am Sensorsystem das Gesamtsystem so kalibriert, dass die Anzeigevorrichtung den Maximalwert anzeigt.

Die Eichung des Minimalwertes kann bei diesem Füllstandsensor entfallen, da nach Kürzung der Kapazitätssensoren die Freiluftkapazität der Stäbe so wenig verändert ist, dass dies nur zu einem unerheblichen Anzeigefehler (beim Zustand "Leer") im Gesamtsystem führt.

### 3. Problem

Universalsensorsysteme (d.h. Systeme die vom Benutzer angepasst werden können) haben Einstellelemente, mit denen eine Eichung durchgeführt werden kann.

Diese Einstellelemente befinden sich üblicherweise direkt am Sensorsystem (vgl. Bild 3), da ein abgesetztes Einstellelement einerseits zu erhöhtem Verdrahtungsaufwand führt und andererseits zu erhöhten Kosten.

Die Platzierung eines Einstellelements direkt am Sensorsystem hat jedoch erhebliche Nachteile. Diese sind im Besonderen ...

a) Ein Sensorsystem wird häufig an einer Stelle montiert, die im späteren Betrieb nicht oder nur sehr schwer zugänglich ist.

Eine Nacheichung ist daher nur mit sehr hohem Demontageaufwand durchzuführen.

b) Ein Sensorsystem befindet sich häufig an Stellen, bei denen eine erhöhte Belastung durch Temperatur, Feuchtigkeit oder mechanischer Beanspruchung auftritt. Daher sind besondere Maßnahmen zu treffen, um das Einstellelement zu schützen und eine Drift des Eichwertes zu verhindern.

Die Ausführung eines Sensorsystems mit einem Einstellelement ist daher problematisch und stellt immer eine Schwachstelle für das Gesamtsystem dar.

### 4. Aufgabe

Ausgehend von diesem Stand der Technik soll ein Verfahren zur Eichung geschaffen werden, das die Nachteile der Eichung von Sensorsystemen mit Einstellelementen am Sensorsystem vermeidet, das keine zusätzlichen Leitungen zum Sensorsystem erfordert und vorzugsweise mit der Verdrahtung herkömmlicher Sensorsysteme durchführbar ist, das ohne besondere Hilfsmittel durchführbar ist, insbesondere keine sendung digitaler Signale an das Sensorsystem erfordert und das einfach und preiswert durchführbar ist.

### 5. Lösung des Problems

Eine Ferneichung des Sensorsystems kann dadurch sehr einfach, wiederholbar und kostengünstig durchgeführt werden, wenn das Sensorsystem so konstruiert wird, dass es die Impedanz der Signalleitung erfassen kann.

Hierzu reicht eine sehr geringe Maschinenintelligenz aus, so dass handelsübliche Halbleiterbauelemente (Kleinstprozessoren) eingesetzt werden können.

Im Normalbetrieb ist ein Sensorsystem mit seiner Signalleitung mit dem Anzeigegerät verbunden. Dieses Anzeigegerät hat einen Innenwiderstand, der üblicherweise im Bereich 50..200 Ohm liegt.

Zur Durchführung einer Eichung, wird das Sensorsystem direkt an die Hauptversorgung (z.B. +12V) angeschlossen. Die Impedanz der Signalleitung wird nun nur noch durch die Leitung und dem Versorgungs-Innenwiderstand bestimmt. Der Innenwiderstand des Signal/Versorgungszweiges ist also wesentlich geringer und liegt im Bereich 0..10 Ohm.

Die beiden grundsätzlichen Zustände (Normalbetrieb / Eichung) können nach Einschalten der Hauptversorgung vom Sensorsystem unterschieden werden.

Dazu schaltet das Sensorsystem ein- oder mehrmals zwischen Minimalstrom und Maximalstrom um und misst das Potenzial an seinem Signal/Versorgungsanschluss.

Der Innenwiderstand (Impedanz) der Signalleitung als Bestandteil des Schaltkreises wird errechnet aus

$$Ri = (Umax - Umin) / (Imax - Imin)$$

Hierbei ist zu bemerken, dass zur Ermittlung eines Innenwiderstandes eine Spannungsmessung an der Klemme "Signal/Versorgung" bei bekanntem Strom ausreicht.

Es muss nicht der Spannungsabfall entlang dem zu messenden Signal/Versorgungszweigs gemessen werden.

Ausreichend ist allein die Ermittlung dU/dI.

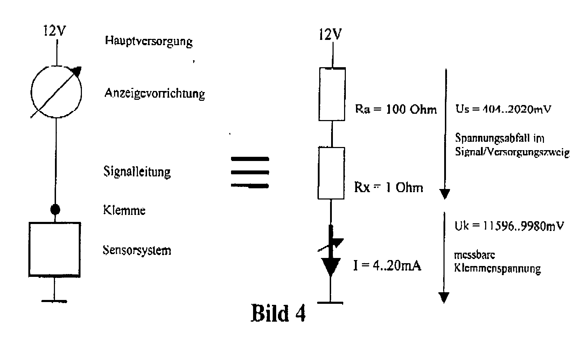

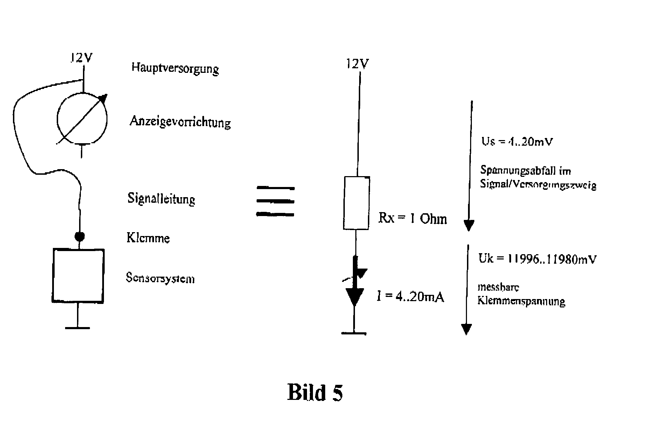

Durch Festlegung eines geeigneten und konstruktiv festzulegenden Schwellwertes Ri kann das Sensorsystem entscheiden, ob die Signalleitung direkt mit der Versorgung verbunden ist (Eichbetrieb - Bild 5), oder ob ein Messinstrument in Keine geschaltet ist (Normalbetrieb - Bild 4)). Bild 4 zeigt eine beispielhafte Darstellung der Potenziale bei angeschlossener Anzeigevorrichtung, also im Normalbetrieb, während Bild 5 eine beispielhafte Darstellung der Potenziale bei Anschluss der Signalleitung an die Hauptversorgung darstellt, also den Eichbetrieb.

Wenn das Sensorsystem aufgrund des ermittelten Innenwiderstands (Impedanz der Signalleitung) in den Eichbetrieb geht, wird der gemessene Sensorwert als Eichpunkt in einem Speicher abgelegt und somit für spätere Berechnungen verwendbar gemacht. Dieser Speicher sollte nicht flüchtig sein.

Wenn das Sensorsystem aufgrund der ermittelten Signalleitungs-Impedanz im Normalbetrieb ist, werden die laufend gemessenen Sensorwerte (d.h. Kapazitätswerte) mit Hilfe des bei der Eichung gespeicherten Eichpunktes skaliert, umgerechnet und korrigiert.

Als Folge der Berechnungen wird im Sensorsystem eine Stromsenke so gesteuert, dass das (entfernte) Anzeigegerät nun den korrekten Wert anzeigt.

Beispielhaft kann nach Kürzung von kapazitiven Messstäben, der abgespeicherte Kapazitätswert als Maximalwert in die Rechnung eingehen und die Steilheit der Senkenstromfunktion $Is = f(C, C\_max)$ wird rechnerisch entsprechend angepasst.

| Kaltstart und Initialisierung | |
| --- | --- |
| Stelle steuerbare Stromsenke auf 4mA | |
| Messe Klemmenspannung → Uk_max | |
| Stelle steuerbare Stromsenke auf 20mA | |
| Messe Klemmenspannung → Uk_min | |
| Bilde dU = Uk_max – Uk_min ; Bilde dI = 20mA – 4mA ; Bilde Rs = dU / dI | |
| Rs < 50 Ohm ? | |
| J (Eichbetrieb) | N (Normalbetrieb) |
| Messe Sensorkapazität C_max | Messe Sensorkapazität C |
| Speichere Eichwert : C_max | Berechne Senkenstrom    Is = f(C, C_max) |
| Warten | Is → steuerbare Stromsenke |
| Endlos | Endlos |

Diagramm 1: vereinfachtes Ablaufdiagramm (ein Eichwert)

## 6. Weitere abgeleitete Lösungen

Alternativ zur Verbindung der Signalleitung mit der Hauptversorgung kann auch auf andere Weise eine messbare und unterscheidbare Impedanzänderung der Signalleitung erzwungen werden.

a) Die Anzeigevorrichtung kann durch ein Bauelement ersetzt werden, dessen Impedanz deutlich von der Impedanz der Anzeigevorrichtung abweicht.

b) Die Anzeigevorrichtung kann mit einem Bauelement überbrückt werden, so dass die resultierende Gesamtimpedanz deutlich von der Impedanz der Anzeigevorrichtung abweicht.

c) Ein Bauelement kann in Reihe zur Anzeigevorrichtung geschaltet werden, so dass die resultierende Gesamtimpedanz deutlich von der Impedanz der Anzeigevorrichtung abweicht.

Soweit eine solche Impedanzänderung feststellbar ist, unterscheidet sich der grundsätzlich Ablauf des Verfahrens nicht vom zuvor dargestellten Verfahren (Diagramm 1).

Die zuvor dargestellte Lösung führt die Eichung lediglich für einen Betriebspunkt durch.

Das vorgestellte Verfahren kann so erweitert werden, dass auch zwei oder mehr Eichpunkte festlegbar sind. In Anlehnung an das zuvor gewählte Beispiel eines Füllstandsensors kann dies eine Festlegung des Leer-Eichwertes und des Voll-Eichwertes sein.

Hierbei kommen folgende Möglichkeiten in Betracht

a) Das sensorsystem ermittelt aufgrund des gemessenen Sensorwertes und aufgrund von festen Schwellwerten, welcher Betriebspunkt zur Eichung vorgesehen ist. (vgl. Diagramm 2)

b) Durch Anlegen des Signalleitung an den Hauptstrom für verschieden lange Zeiten kann das Sensorsystem ermitteln, welcher Eichpunkt abzuspeichern ist. (vgl. Diagramm 3)

c) In Anlehnung an die zuvor beschriebene Einfügung von speziellen Bauelementen zur gezielten Impedanzverschiebung, können verschiedene Bauelemente verwendet werden und anhand von Schwellwerten bei der Impedanzmessung unterscheidet das Sensorsystem die zu speichernden Eichpunkte.

| Kaltstart und Initialisierung |
|---|
| Stelle steuerbare Stromsenke auf 4mA |
| Messe Klemmenspannung → Uk_max |
| Stelle steuerbare Stromsenke auf 20mA |
| Messe Klemmenspannung -> Uk_min |
| Bilde dU = Uk_max – Uk_min ; Bilde dI = 20mA – 4mA; Bilde Rs = dU / dI |

J (Eichbetrieb) — Rs < 50 Ohm ? — N (Normalbetrieb)

| Messe Sensorkapazität C | Messe Sensorkapazität → C |
|---|---|
| N (Leer) — C < Schwellwert — J (Voll) | Berechne Senkenstrom Is = f(C, C_min, C_max) |
| Speichere C → C_min / Speichere C → C_max | |
| Warten | Is → steuerbare Stromsenke Endlos |
| Endlos | |

Diagramm 2: vereinfachtes Ablaufdiagramm (zwei Eichwerte, Entscheidung durch Schwellwert)

| Kaltstart und Initialisierung |
|---|
| Stelle steuerbare Stromsenke auf 4mA |
| Messe Klemmenspannung → Uk_max |
| Stelle steuerbare Stromsenke auf 20mA |
| Messe Klemmenspannung Uk_min |
| Bilde dU = Uk_max − Uk_min ; Bilde dI = 20mA − 4mA; Bilde Rs = dU / dI |

Rs < 50 Ohm
?

J (Eichbetrieb)        N (Normalbetrieb)

| J (Eichbetrieb) | N (Normalbetrieb) |
|---|---|
| C_max → C_max_alt (Zwischenspeicher für Eichwert-Voll) | Messe Sensorkapazität C |
| Messe Sensorkapazität C | |
| C → C_max (Abspeicherung Eichwert-Voll) | Berechne Senkenstrom Is = f(C, C_min, C_max) |
| Warten | |
| solange t < 1 Min | |
| C_max_alt → C_max (Wiederherstellung Eichwert-Voll) | |
| C → C_min (Abspeicherung Eichwert-Leer) | |
| Warten | Is → steuerbare Stromsenke |
| Endlos | Endlos |

Diagramm 3: vereinfachtes Ablaufdiagramm (zwei Eichwerte, Entscheidung durch Eichzeit)

### 7. Vorteile

Das hier vorgestellte Verfahren zur Eichung von Sensorsystemen zeichnet sich dadurch aus, dass keine Einstellelemente an den Sensorsystemen erforderlich sind. Daher kann eine optimale konstruktive Anpassung an die Bedingungen erreicht werden. Beispielsweise kann das Sensorsystem gekapselt oder mit Kunststoff vergossen werden.

Die Eichung erfolgt ohne besondere Hilfsmittel, sondern lediglich durch Umstecken der Signalleitung auf die Hauptversorgungsschiene oder durch Überbrücken des Anzeigeinstrumentes.

Die Eichung wird am Montageort des Anzeigeinstrumentes ausgelöst, der besser zugänglicher ist, als der Montageort des Sensorsystems.

Das Sensorsystem ist nach der Eichung verhaltensidentisch zu herkömmlichen Sensorsystemen und kann daher auch in bestehende Installationen integriert werden. Die vorhandene Verdrahtung muss nicht geändert werden.

Da moderne Sensorsysteme häufig bereits mit Kleinstprozessoren ausgestattet sind, stellt das Verfahren keinen besonderen Kostennachteil gegenüber dem Stand der Technik dar.

Das Verfahren ist daher in allen Punkten gegenüber den bestehenden Realisationen überlegen und stellt eine Verbesserung der Sensortechnik dar.

### Patentansprüche

1. Verfahren zur Eichung eines Schaltkreises mit einem Sensorsystem mit aktiver Halbleiterschaltung, das über eine Signalleitung mit einer Anzeigevorrichtung verbunden ist, wobei der minimale Anzeigewert der Anzeigevorrichtung bei einem ersten und der maximale Anzeigewert der Anzeigevorrichtung bei einem zweiten Stromwert erreicht wird, und das Sensorsystem eine steuerbare Stromsenke aufweist, die eine Einstellung des in der Signalleitung fließenden Stroms zwischen dem ersten und dem zweiten Stromwert erlaubt, **dadurch gekennzeichnet, dass**

- zur Durchführung der Eichung der Innenwiderstand des Schaltkreises zeitweilig geändert wird
- das sensorsystem den Innenwiderstand ertasst und abhängig von dem erfassten Innenwiderstand zwischen dem Eichbetrieb und Normalbetrieb der Anzeigevorrichtung wechselt
- das Sensorsystem während der Eichung mindestens einen Messwert des Sensorssystems als Eichpunkt in einem Speicher ablegt und
- das Sensorsystem in Normalbetrieb der Anzeigevorrichtung den oder die im Speicher abgelegten Eichpunkte zur Berechnung von Korrekturwerten für die steuerbare Stromsenke verwendet, um auf der Anzeigevorrichtung den korrekten Wert anzuzeigen.

2. Verfahren nach Anspruch 1, **dadurch gekennzeichnet, dass** der Innenwiderstand des Schaltkreises verändert wird, in dem die zur Anzeigevorrichtung führende Signalleitung zeitweilig direkt mit der Stromversorgung verbunden wird und das Sensorsystem bei direkter Verbindung mit der Stromversorgung in den Eichbetrieb wechselt.

3. Verfahren nach Anspruch 1, **dadurch gekennzeichnet, dass** der Innenwiderstand des Schaltkreises verändert wird, in dem in die zur Anzeigevorrichtung führende Signalleitung zeitweilig mindestens ein den Widerstand veränderndes Bauelemente hinzugefügt wird.

4. Verfahren nach einem der Ansprüche 1 bis 3, **dadurch gekennzeichnet, dass** das Sensorsystem mehrere Messwerte des Sensorssystems als Eichpunkte in dem Speicher ablegt und im Eichbetrieb anhand von Schwellwertvergleichen die gemessenen Sensorwerte den jeweiligen Eichpunkten zuordnet.

5. Verfahren nach Anspruch 4, **dadurch gekennzeichnet, dass** zur Erzeugung unterschiedlicher Eichpunkte in die zur Anzeigevorrichtung führende Signalleitung zeitweilig verschiedene den Widerstand verändernde Bauelemente eingefügt werden.

6. Verfahren nach einem der Ansprüche 1 bis 3, **dadurch gekennzeichnet, dass** das Sensorsystem mehrere Messwerte des Sensorssystems als Eichpunkte in dem Speicher ablegt und im Eichbetrieb anhand der Messdauer die gemessenen Sensorwerte den jeweiligen Eichpunkten zuordnet.

7. Sensorsystem mit aktiver Halbleiterschaltung, das einen Anschluss für eine Signalleitung zur Verbindung mit einer Anzeigevorrichtung aufweist, wobei das Sensorsystem eine von der Halbleiterschaltung nach einem der Ansprüche 1 bis 6 steuerbare Stromsenke aufweist.

8. Sensorsystem nach Anspruch 7, **dadurch gekennzeichnet, dass** der Anschluss zugleich der Stromversorgung des Sensorsystems dient.

Zeigerausschlag

100%

0%

4mA

20mA

Stromfluss

**Bild 1**

Anzeigevorrichtung

Hauptversorgung

4..20mA

Signalleitung

+ −

12V

Sensorsystem

Chassis (Masse)

**Bild 2**

**Bild 3**

**Bild 4**

Hauptversorgung

Anzeigevorrichtung

Signalleitung

Klemme

Sensorsystem

$Ra = 100\ Ohm$

$Rx = 1\ Ohm$

$I = 4..20mA$

$Us = 104..2020mV$

Spannungsabfall im Signal/Versorgungszweig

$Uk = 11596..9980mV$

messbare Klemmenspannung

12V     Hauptversorgung

     Anzeigevorrichtung

                    12V

                                        Us = 4..20mV

                                        Spannungsabfall im
                                        Signal/Versorgungszweig
     Signalleitung
                              Rx = 1 Ohm

     Klemme
                                        Uk = 11996..11980mV
     Sensorsystem
                              I = 4..20mA     messbare
                                              Klemmenspannung

## Bild 5

**Europäisches Patentamt**

# EUROPÄISCHER RECHERCHENBERICHT

**Nummer der Anmeldung**

EP 06 00 7472

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | EP 0 433 995 A (DREXELBROOK CONTROLS, INC) 26. Juni 1991 (1991-06-26) | 1 | INV. G08C19/02 G01D18/00 G01R35/00 |
| A | * Spalte 4, Zeile 1 - Spalte 8, Zeile 1; Abbildungen 1-3 * | 7 | |
| X | US 4 723 122 A (MALTBY ET AL) 2. Februar 1988 (1988-02-02) * Spalte 6, Zeile 28 - Spalte 11, Zeile 28; Abbildungen 1-4 * | 7 | |
| A | * Spalte 12, Zeile 50 - Spalte 13, Zeile 15; Abbildung 6 * | 1 | |
| X | WO 88/01417 A (ROSEMOUNT INC) 25. Februar 1988 (1988-02-25) | 7 | |
| A | * Seite 4, Zeile 21 - Seite 9, Zeile 6; Abbildung 1 * | 1 | |
| X | US 5 253 511 A (JARAMILLO ET AL) 19. Oktober 1993 (1993-10-19) | 7 | |
| A | * Spalte 1, Zeile 59 - Spalte 4, Zeile 46; Abbildungen 1,2 * | 1 | |

**RECHERCHIERTE SACHGEBIETE (IPC)**

G08C
G01D
G01R
G01F

Der vorliegende Recherchenbericht wurde für alle Patentansprüche erstellt

| Recherchenort | Abschlußdatum der Recherche | Prüfer |
|---|---|---|
| München | 25. August 2006 | Hijazi, A |

EPO FORM 1503 03.82 (P04C03)

**ANHANG ZUM EUROPÄISCHEN RECHERCHENBERICHT**
**ÜBER DIE EUROPÄISCHE PATENTANMELDUNG NR.**

EP 06 00 7472

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

25-08-2006

| Im Recherchenbericht angeführtes Patentdokument | | Datum der Veröffentlichung | Mitglied(er) der Patentfamilie | | | Datum der Veröffentlichung |
|---|---|---|---|---|---|---|
| EP 0433995 | A | 26-06-1991 | CA | 2032384 | A1 | 19-06-1991 |
| | | | DE | 69031456 | D1 | 23-10-1997 |
| | | | DE | 69031456 | T2 | 05-02-1998 |
| | | | JP | 2856555 | B2 | 10-02-1999 |
| | | | JP | 4211899 | A | 03-08-1992 |
| US 4723122 | A | 02-02-1988 | CA | 1258691 | A1 | 22-08-1989 |
| | | | DE | 3636111 | A1 | 30-04-1987 |
| | | | GB | 2184241 | A | 17-06-1987 |
| | | | JP | 62162199 | A | 18-07-1987 |
| WO 8801417 | A | 25-02-1988 | AT | 181611 | T | 15-07-1999 |
| | | | CA | 1300924 | C | 19-05-1992 |
| | | | DE | 3752283 | D1 | 29-07-1999 |
| | | | EP | 0328520 | A1 | 23-08-1989 |
| US 5253511 | A | 19-10-1993 | KEINE | | | |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 10258417 B3